# EUROPEAN PATENT APPLICATION

(11) **EP 1 599 077 A1**
(43) Date of publication of application: **23.11.2005**
(21) Application number: 05291071.8
(22) Date of filing: 18.05.2005
(51) Int. Cl.: H05K 1/11, H05K 3/40, H05K 3/36

(54) **Method of creating gold contacts directly on printed circuit boards and product thereof**

(30) Priority: 19.05.2004 US 572661 P
(71) Applicant: Aries Electronics, Inc, Frenchtown, New Jersey 08825 (US)
(72) Inventor: Walter, James P., Kintnersville Pennsylvania (US); Sinclair, William Y., Frenchtown New Jersey (US)
(74) Representative: Chameroy, Claude

(57) **Abstract**

A method of creating domed shaped contacts on a printed circuit board (12) includes etching or drilling a central opening in each copper pad (14), and then screening a mound of silver epoxy into the opening. The silver epoxy above the pad slumps to form a domed bump. The silver epoxy is then cured and is coated, in turn, by a layer of electroless nickel (24) and gold (26). The resulting gold plated contacts are of monolithic structure and function to facilitate connection to a mezzanine board.

## Description

This application claims priority from U.S. Provisional Application No. 60/572,661, filed May 19, 2004, which is incorporated herein by reference.

### BACKGROUND OF THE INVENTION

### Field of the Invention

The present invention relates to a method of creating gold plated bumps or protrusions on copper pads of a printed circuit board so as to result in an external surface having a high density of electrically conductive contacts concentrated within a very small area and designed to facilitate ready interconnection to another printed circuit board.

### Description of the Related Art

In order to interconnect one printed circuit board to another printed circuit board, several prior art processes are presently being employed. In one process, wires are individually interconnected between the contacts of one board to the contacts of another board by means of soldered connections. This is a very tedious and time consuming process and is very difficult in view of the close spacing between adjacent contacts. As an example, it is only practical to interconnect two circuit boards utilizing the wire interconnection technique when the spacing between the contacts is at least on the order of 0.020 inches. Normally, wire interconnections between printed circuit boards are typically employed when the contacts are spaced at 0.050 inches.

Another prior art technique is to utilize solder balls. More particularly, a solder ball is attached to each copper pad of a printed circuit board, and the solder balls thus present protrusions for connection to the pads of a second or mezzanine printed circuit board. The solder balls are connected to the pads of the mezzanine board by using infrared or some other form of heating to reflow the solder balls. The problem with this technique is that, as the solder balls are heated, they tend to slump, thereby restricting the amount of spacing between adjacent solder pads.

As a result of the foregoing deficiencies in the prior art techniques for interconnecting printed circuit boards, there is a need for a new and improved technique for interconnecting printed circuit boards which will enable the contact pads to be spaced at the minimum spacing and preferably as little as 0.015 inches.

### Summary of the Invention

An object of the subject invention is to provide a method of creating gold contacts directly on printed circuit boards.

A further object of the subject invention is to provide a method of creating gold contacts directly on a printed circuit board, with the gold contacts being anchored to the substrate of the printed circuit board.

It is a further object of the subject invention to provide a method of creating gold contacts directly on a printed circuit board such that the contacts may be directly connected to a mezzanine printed circuit board, without the gold contacts slumping or expanding during the connection process when the boards are heated.

It is another object of the subject invention to provide a new and improved printed circuit board having raised gold contacts which provide a standoff for spacing a mezzanine printed circuit board.

It is still a further object of the subject invention to provide a new and improved printed circuit board having raised gold contacts which may be readily connected to a mezzanine printed circuit board.

The above and other objects are achieved by the method of the subject invention which includes the following steps. First, a silver epoxy is deposited via a stencil in exactly equal amounts into a central hole that has been etched in a standard printed circuit board copper pad. The hole is filled with the silver epoxy and an extra amount of silver epoxy is deposited above the surface of the copper pad to create a bump or domed configuration. The silver epoxy deposited tends to slump so as to create a rounded bump or dome above the surface of the substrate. The bump is achievable because of the fact that the stencil is of a sufficient thickness to create the bump.

The next step in the subject process is that the silver epoxy "bump" is then heat cured so that it remains in a stable configuration above the copper pad on the printed circuit board. The board is then cleaned and thoroughly dried.

In the next step of the process of the subject invention, an electroless nickel plating is then applied to the entire surface of the copper pad and the silver epoxy bump. The nickel coating is then rinsed with clean water, after which the printed circuit board is plated with an emersion gold finish. The result is a printed circuit board with gold plated bumps or contacts ready for soldering to a mezzanine printed circuit board.

The resulting structure provides for a high-density contact matrix, with each of the contacts being uniformly disposed above the plane of the printed circuit board substrate and readily adapted for connection to a mezzanine printed circuit board.

Furthermore, the gold plated bumps are of rigid structure and hence will not expand radially as the printed circuit boards are heated during interconnection. The gold plated bumps function as a standoff to space the mezzanine printed circuit board from the subject printed circuit board which facilitates cleaning of the boards, reduces co-planiarity problems and reduces reflow issues.

Each gold contact of the resulting printed circuit board is a monolithic structure of enhanced strength, with the silver epoxy being adhesively bonded to the substrate of the printed circuit board.

In an alternate embodiment of the method and product of the subject invention, first, a hole is drilled in the center of a copper pad and into the printed circuit board substrate to a depth of, for example, 0.015 inches. Next, silver epoxy is deposited via a stencil in exactly equal amounts onto the copper pad. Each hole is filled with the silver epoxy and an extra amount of silver epoxy is deposited above the surface of the copper pad to create a bump or dome. The bump is achievable because of the fact that the stencil is of a sufficient thickness to create the bump, and usually the thickness of the stencil is equal to the depth of the hole which is drilled in the copper pad, and this is usually 0.015 inches. After the stencil is removed, the silver epoxy slumps to create a rounded bump. Furthermore, the silver epoxy adhesively bonds to the substrate.

The next step in the subject process is that the silver epoxy "bump" is then heat cured so that it remains in a stable configuration above the copper pad on the printed circuit board. Following the curing step, the board is then cleaned and thoroughly dried.

In the next step of the process of the subject invention, an electroless nickel plating is then applied to the entire surface of the copper pad and the silver epoxy bump. The nickel coating is then rinsed with clean water, after which the printed circuit board is plated with an emersion gold finish.

### Brief Description of the Drawings

FIG. 1 is a top plan view of the new and improved printed circuit board of the subject invention including the gold contacts;

FIG. 2 is a top plan view of one of the gold contacts as shown in FIG. 1;

FIG. 3 is a cross-sectional view illustrating the first step in the method of the subject invention;

FIG. 4 is a cross-sectional view illustrating the next step in the method of the subject invention;

FIG. 5 is a cross-sectional view illustrating the next step in the subject method;

FIG. 6 is a cross-sectional view taken along line 6-6 of FIG. 2 and illustrating the last step in the subject method;

FIG. 7 is a cross-sectional view illustrating the first step of a second embodiment of the subject method;

FIG. 8 is a cross-sectional view illustrating the next step in the second embodiment of the subject method;

FIG. 9 is a cross-sectional view illustrating the next step in the second embodiment of the subject method; and

FIG. 10 is a cross-sectional view illustrating the last step and the final configuration of the gold contact made according to the second embodiment of the subject method.

### Detailed Description of the Preferred Embodiment

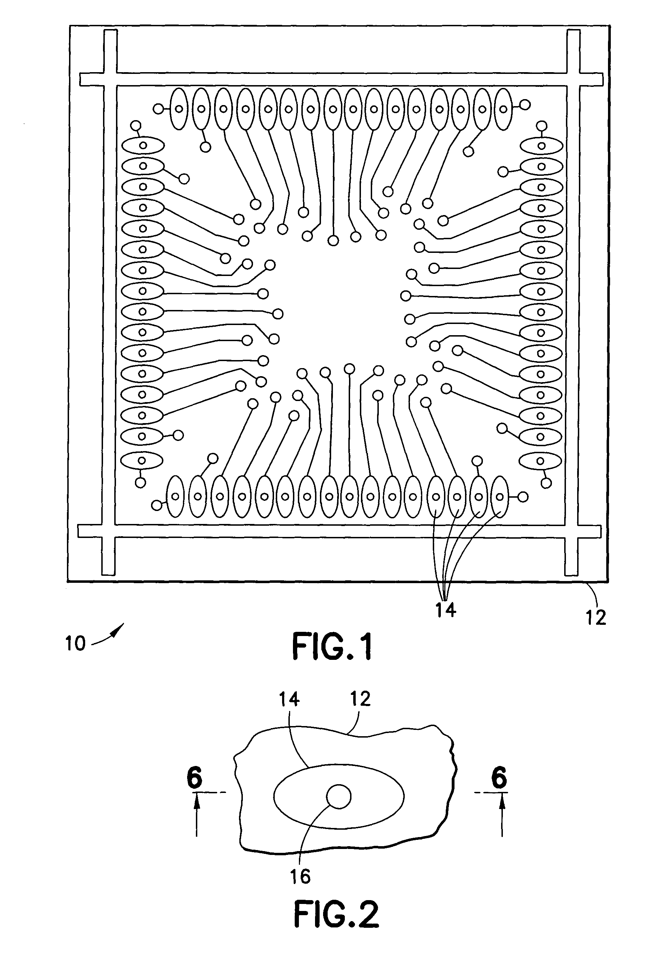

Referring to FIGS. 1 and 2, a printed circuit board 10 includes a substrate 12 as well as a plurality of elliptically shaped pads 14. Each pad 14 includes a central bump or protrusion 16 which extends above the surface of the pad 14. The configuration of the pad may also be round, or any other configuration, with the bump or protrusion 16 being disposed generally centrally within the surface of the pad 14. Preferably, each pad 14 is coated with a layer of gold in order to enhance its electrical conducting capabilities.

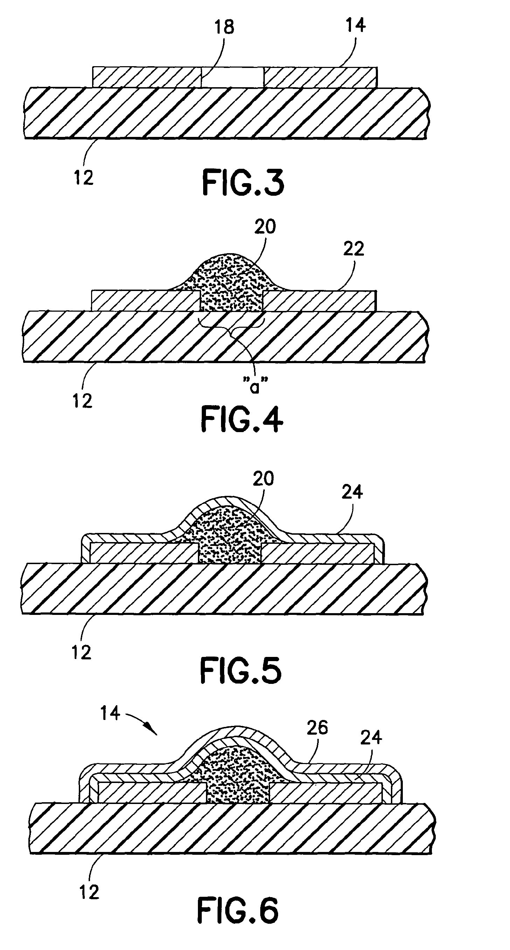

FIGS. 3-6 illustrate the several steps in the method of making the gold coated pads 14.

Turning to FIG. 3, the first step in the subject method is to etch each pad 14 to include a central hole 18. This is accomplished using standard printed circuit board etching techniques including placing a stencil over the printed circuit board, with openings centered on the respective openings 18, and with the thickness of the stencil corresponding to the desired thickness of the bump 16, and this is usually approximately 0.015 inches.

Turning to FIG. 4, in the next step of the subject method, silver epoxy 20 is deposited by a stencil in each of the holes 18, with a portion of the silver epoxy 20 extending above the top surface of the copper pad 22. After the stencil is removed, the silver epoxy slumps to a rounded or domed configuration because of the viscosity of the silver epoxy at this time. The printed circuit board is then heat cured, and the silver epoxy bump is cured to a hardened condition.

The printed circuit board is then cleaned and thoroughly dried.

The silver epoxy bump 20 is adhesively bonded to the substrate 12 along the area designated "a" where the silver epoxy bump 20 engages the printed circuit board 12.

Turning to FIG. 5, in the next step of the subject method, an electroless nickel plating 24 is applied to all of the surfaces of the copper pad 22 and the silver epoxy bump 20. This is usually performed by dunking the entire printed circuit board in a vat containing electroless nickel and maintaining the printed circuit board in the vat until the desired level or thickness of electroless nickel plating 24 is achieved. During this time, there is a chemical reaction which takes place between the electroless nickel plating 24 and the silver epoxy 20, as well as with the copper pad 22. The purpose of the electroless nickel coating 24 is to establish a base for subsequent plating with a gold finish to enhance the electrical contact between the bump 16 and the mezzanine printed circuit board.

The printed circuit board is again rinsed with clean water to remove any excess nickel coating, after which the printed circuit board is immersed in a gold finish to result in a thin gold plating layer 26 (see FIG. 6) applied to the bump 20 and the copper pad 22.

The electroless nickel plating 24 is very thin, usually on the order of 0.001 inches thickness, with the gold plating finish 26 being on the order of a single angstrom.

As more particularly shown in FIG. 6, the gold plated bump extends substantially above the top surface of the substrate 12 of the printed circuit board 10, thereby readily facilitating the connection of the printed circuit board 10 to a mezzanine printed circuit board. In addition to facilitating interconnection to the mezzanine printed circuit board, the height of the bumps allows enough room to clean between the two interconnected boards, as well as facilitating inspection of the connections. It also allows for sufficient clearance for electrical purposes and reduces co-planarity problems and reduces reflow issues.

Interconnection between the printed circuit board 10 and the mezzanine board is performed in the usual manner utilizing a solder paste followed by heat in the form of infrared or vapor phase heating until such time as the solder reaches a melt temperature.

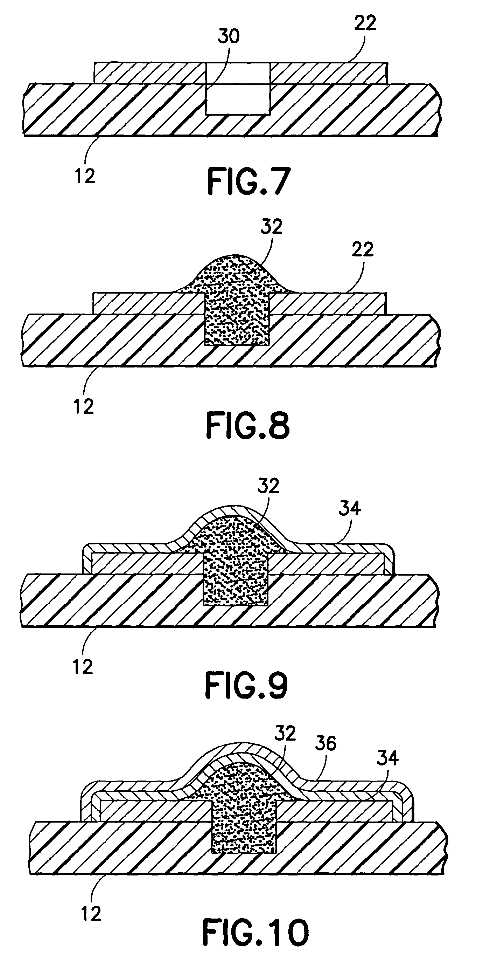

FIGS. 7-10 illustrate a second embodiment of the method of the subject invention. As illustrated in FIG. 7, the first step in the second embodiment is the drilling of a hole 30 through the copper pad 22 and into the substrate 12. The depth of the hole 30 in the substrate 12 is approximately equal to the height of the silver epoxy extending above the surface of the substrate 12.

After the hole 30 is drilled through the copper pad 22, a stencil is placed over the printed circuit board, with openings centered on the respective holes 30, and with the thickness of the stencil corresponding to the desired thickness of the bump and, more particularly, approximately 0.015 inches.

Next, as illustrated in FIG. 8, silver epoxy 32 is deposited via a stencil in each of the holes 30, with a portion of the silver epoxy extending above the top surface of the substrate 12 to the desired height. After the stencil is removed, the viscosity of the silver epoxy 32 will cause it to slump, to a rounded or dome shaped configuration, as shown in FIG. 8.

The deposited silver epoxy 32, including the portion extending above the surface of the substrate 22, is then heat cured.

The printed circuit board is then cleaned and thoroughly dried.

In the next step of the subject method, as illustrated in FIG. 9, an electroless nickel plating 34 is applied to the surfaces of the copper pad 22 and the silver epoxy bump 32. This is usually performed by dunking the entire printed circuit board in a vat containing electroless nickel and maintaining the printed circuit board in the vat until the desired level or thickness of electroless nickel plating is achieved. During this time, there is a chemical reaction which takes place between the electroless nickel plating and the silver epoxy, as well as with the copper pad. The purpose of the electroless nickel coating is to establish a base for subsequent plating with a gold finish to enhance the electrical contact between the silver epoxy bump 32 and a mezzanine printed circuit board.

The silver epoxy bump 32, following curing, is adhesively bonded to the walls of the hole 30 in the substrate 12, as well as to the copper pad 22.

The printed circuit board is again rinsed with clean water to remove any excess nickel coating, after which the printed circuit board is immersed in a gold finish to result in a thin gold plating layer 36 (see FIG. 10).

The present invention is not to be limited in scope by the specific embodiments described herein. Indeed, various modifications of the invention in addition to those described herein will become apparent to those skilled in the art from the foregoing description and accompanying Figures. Such modifications are intended to fall within the scope of the appended claims.

## Claims

1. A printed circuit board comprising:
a substrate; and
a plurality of pads disposed on said substrate, each pad having a generally central bump formed of silver epoxy secured to said substrate and extending from the surface of said substrate, said silver epoxy being coated, in turn, by layers of nickel and gold.

2. A printed circuit board as in claim 1 wherein the substrate includes a plurality of holes corresponding to the plurality of pads, and wherein the silver epoxy of each pad also extends into the respective hole in the substrate.

3. A printed circuit board as in claim 1 wherein the bump has a generally dome configuration.

4. A printed circuit board as in claim 1 wherein the layer of nickel is electroless nickel plating.

5. A printed circuit board as in claim 4 wherein the thickness of the electroless nickel plating is 0.001 inches in thickness.

6. A method of making a printed circuit board having a plurality of gold plated contact pads comprising the steps of:
providing a plurality of spaced copper pads;
etching each copper pad to include a generally central hole therein;
screening silver epoxy into each said hole and extending above said copper pad;
curing said silver epoxy;
coating said cured silver epoxy and the copper pad with a layer of nickel; and
coating said nickel-coated cured silver epoxy with a layer of gold.

7. A method of making a printed circuit board having a plurality of gold plated contact pads as in claim 6 wherein the screened silver epoxy is allowed to slump to a domed configuration prior to the step of curing said silver epoxy.

8. A method of making a printed circuit board having a plurality of gold plated contact pads as in claim 6 wherein the nickel is electroless nickel plating.

9. A method of making a printed circuit board having a plurality of gold plated contact pads comprising the steps of:
providing a plurality of spaced copper pads;
drilling a central hole through each said copper pad and partially into the substrate of the printed circuit board;
screening silver epoxy into each said hole and extending above said copper pad;
curing said silver epoxy;
coating said cured silver epoxy and the copper pad with a layer of nickel; and
coating said nickel-coated cured silver epoxy with a layer of gold.

10. A method of making a printed circuit board having a plurality of gold plated contact pads as in claim 9 wherein the screened silver epoxy is allowed to slump into a domed configuration prior to the step of curing said silver epoxy.
